(19) Europäisches Patentamt
European Patent Office
Office européen des brevets

(11) **EP 2 129 198 A1**

(12) **EUROPEAN PATENT APPLICATION**

(43) Date of publication:
**02.12.2009 Bulletin 2009/49**

(51) Int Cl.:
**H05K 3/04** *(2006.01)* **H05K 3/10** *(2006.01)*
**H05K 3/42** *(2006.01)*

(21) Application number: **09159826.8**

(22) Date of filing: **08.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **09.05.2008 JP 2008123442**

(71) Applicant: **Canon Kabushiki Kaisha Tokyo 146-8501 (JP)**

(72) Inventor: **Hombo, Tsunao Ohta-ku Tokyo (JP)**

(74) Representative: **Hitching, Peter Matthew Canon Europe Ltd 3 The Square Stockley Park Uxbridge Middlesex UB11 1ET (GB)**

(54) **Electronic apparatus**

(57)    An image reading apparatus that operates in accordance with a driving signal at a predetermined frequency includes a document illumination board with a wiring pattern made of a conductor, wherein an inductor is provided at an interval smaller than a predetermined interval onto a wiring pattern having a length equal to or larger than a predetermined length at which resonance is generated due to the driving signal having the predetermined frequency.

FIG. 1A

# FIG. 1B

**Description**

BACKGROUND OF THE INVENTION

Field of the Invention

The present invention relates to an electronic apparatus that operates in accordance with a driving signal of a predetermined frequency.

Description of the Related Art

Some conventional image reading apparatuses such as copying machines read documents by moving a reading unit in a scanning manner, which is equipped with a light source and an image sensor, as discussed in Japanese Patent Application Laid-Open No. 8-195860. The reading unit is connected with an image signal receiving unit via a cable such as a flexible cable, which is an image signal transmitting medium. An image reading apparatus with such a structure has an advantage of reducing apparatus thickness and is suitable for a small-sized apparatus.

However, sometimes the reading unit may be in an electrically floating state, which may cause radiation noise due to a driving signal to an image sensor of the reading unit. A driving signal to a light source and an image sensor requires a high current. In addition, high-speed reading requires use of a high-frequency signal. Accordingly, radiation noise occurs between the reading unit and an integrated circuit (IC) that drives the light source and the image sensor.

As measures against radiation noise, there have been discussed an image reading apparatus including an electrostatically shielded flexible cable in Japanese Patent Application Laid-Open No. 2-308667 and a platen glass made of a transparent conductive member.

Such measures are effective for the radiation noise emitted from a flexible cable, but are ineffective for the radiation noise emitted from a reading unit itself.

The conductive platen glass generally has a conductive coating of several micrometers applied onto a surface thereof. However, since the coating may be easily worn and peeled off after documents are repeatedly placed on the platen glass, a radiation noise suppression effect does not last in proportion to the cost increase.

Further, radiation noise may be generated in a case where resonance may occur on a wiring pattern in a circuit board of a reading unit due to a relationship between a length of the wiring pattern and a frequency of the radiation noise. Hence, the wiring pattern may operate as an antenna which radiates the radiation noise.

SUMMARY OF THE INVENTION

The present invention is directed to an electronic apparatus capable of preventing radiation noise from being radiated from a wiring pattern on a circuit board due to resonance generated at the wiring pattern on the circuit board which has received the radiation noise.

The present invention is also directed to an electronic apparatus that operates in accordance with a driving signal at a predetermined frequency.

According to an aspect of the present invention, there is provided an electronic apparatus that operates in accordance with a driving signal having a predetermined frequency as specified in claims 1 to 6.

Further features and aspects of the present invention will become apparent from the following detailed description of exemplary embodiments with reference to the attached drawings.

BRIEF DESCRIPTION OF THE DRAWINGS

The accompanying drawings, which are incorporated in and constitute a part of the specification, illustrate exemplary embodiments, features, and aspects of the invention and, together with the description, serve to explain the principles of the invention.

Figs. 1A and 1B illustrate an image reading apparatus according to an exemplary embodiment of the present invention. Fig. 1A is a top view, and Fig. 1B is a sectional view.

Fig. 2 illustrates a functional block diagram of the image reading apparatus.

Figs. 3A and 3B illustrate a configuration of a document illumination circuit board according to a first exemplary embodiment. Fig. 3A illustrates a circuit diagram, and Fig. 3B illustrates a wiring pattern.

Figs. 4A, 4B, and 4C illustrate a document illumination circuit board according to a second exemplary embodiment. Fig. 4A illustrates a circuit diagram, Fig. 4B illustrates a wiring pattern on a front face of the document illumination circuit board, and Fig. 4C illustrates a wiring pattern on a rear face of the document illumination circuit board.

Figs. 5A and 5B illustrate an image sensor circuit board according to a third exemplary embodiment. Fig. 5A illustrates a wiring pattern, and Fig. 5B is an enlarged view of an area A in Fig. 5A.

Figs. 6A and 6B illustrate a reflector according to a fourth exemplary embodiment. Fig. 6A is a top view and Fig. 6B is a sectional view.

DETAILED DESCRIPTION OF THE EMBODIMENTS

Various exemplary embodiments, features, and aspects of the invention will be described in detail below with reference to the drawings.

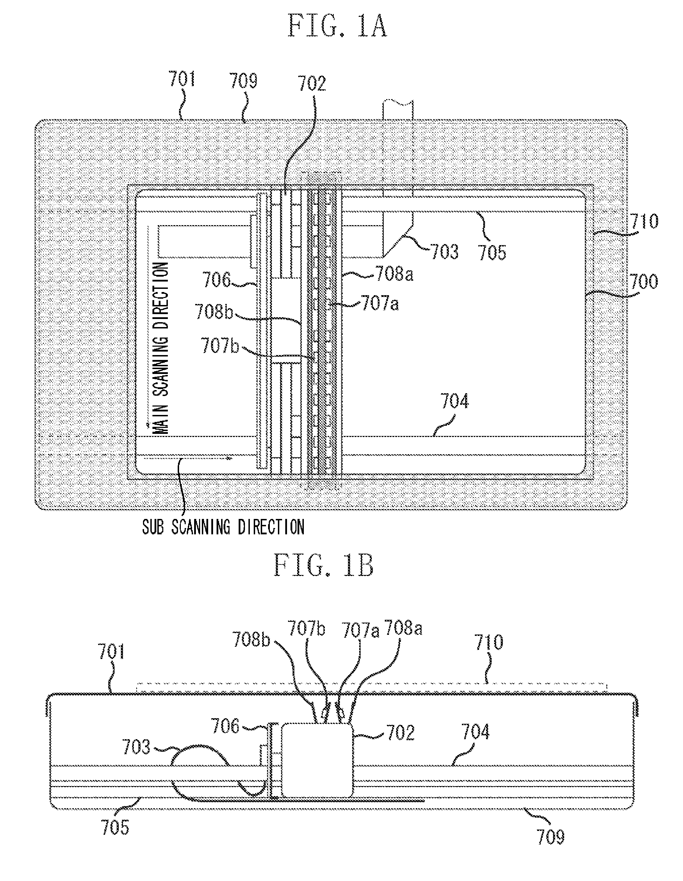

A first exemplary embodiment of the present invention will be described below. Figs. 1A and 1B illustrate an image reading apparatus according to an exemplary embodiment of the present invention. Fig. 1A is a top view, and Fig. 1B is a sectional view. An outer frame includes an upper frame 701 and a lower frame 709 of a housing which are conductive members. An opening 700 is provided with a platen glass 710. By moving a reading unit 702 from the left to the right in Fig. 1A, the reading unit 702 reads an image of a document placed on the platen glass 710.

The reading unit 702 includes an image sensor circuit board 706, document illumination circuit boards 707a and 707b, and reflectors 708a and 708b. Point light sources provided on the document illumination circuit boards 707a and 707b expose the document placed on the platen glass 710 during an image reading operation. The reflected light from the document is focused on an image sensor 711 mounted on the image sensor circuit board 706.

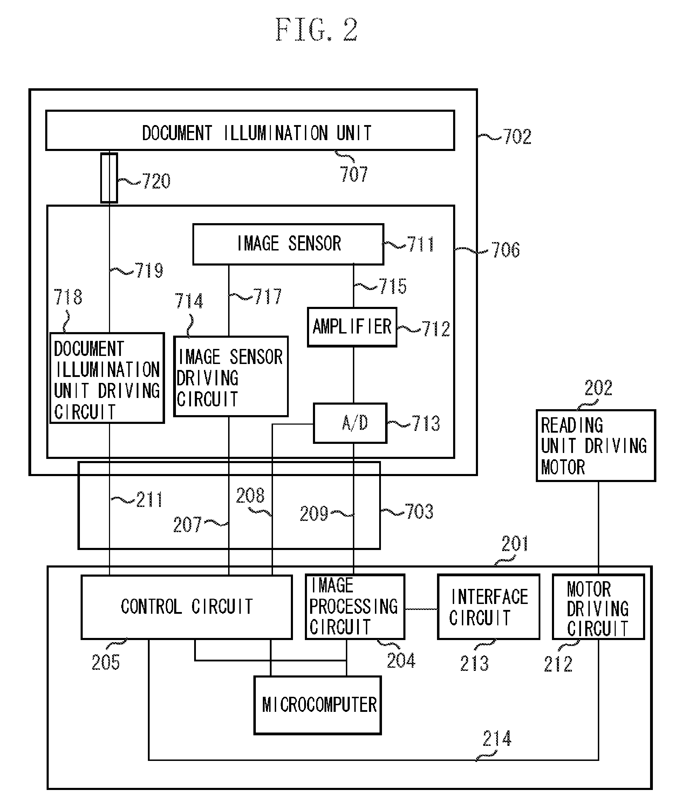

The reading unit 702 is connected with a control circuit board 201 illustrated in Fig. 2 via a cable 703. Point light sources (light emitting diodes (LEDs)) are arranged in a line in a main scanning direction on the document illumination circuit boards 707a and 707b. The document illumination circuit boards 707a and 707b have almost the same length as that of an image reading area in the main scanning direction. The reflectors 708a and 708b reflect and concentrate the reflected light from the document illumination circuit boards 707a and 707b toward a document on the platen glass 710. The reflectors 708a and 708b are formed by vapor-depositing metal onto a base member and have a length equal to or larger than those of the document illumination circuit boards 707a and 707b.

A drive shaft 704 and a guide rail 705 maintain a posture of the reading unit 702 to be horizontal while the reading unit 702 is moving in a sub scanning direction for an image reading operation. The control circuit board 201 is fixed onto the lower frame 709. Both ends of each of the drive shaft 704 and the guide rail 705 are grounded onto the upper frame 701 and the lower frame 709 respectively. The image sensor circuit board 706 is disposed so that a longitudinal direction thereof is orthogonal to those of the drive shaft 704 and the guide rail 705.

Fig. 2 is a functional block diagram of the image reading apparatus. The image sensor 711 mounted on the image sensor circuit board 706 receives the reflected light from a document exposed by the document illumination circuit board 707, and converts the light into an image signal 715, and outputs it. An A-D converter 713 converts the image signal 715 output from the image sensor 711 into an image data 209 via an amplifier 712. The image data 209 is transmitted to an image processing circuit 204 on the control circuit board 201 via a cable 703.

The image processing circuit 204 executes predetermined image processing such as γ correction for the input image data 209. The image data, after being subjected to image processing, is transmitted to an image forming apparatus (not illustrated) via an interface circuit 213. The image forming apparatus forms an image on recording paper based on transmitted image data.

A control circuit 205 on the control circuit board 201 generates a reference signal 207 for driving the image sensor 711 and transmits the reference signal 207 to an image sensor driving circuit 714 on the image sensor circuit board 706 via the cable 703. The image sensor driving circuit 714 generates an image sensor driving signal 717 from the reference signal 207 generated by the control circuit 205 to drive the image sensor 711.

The control circuit 205 generates a reference clock signal 208 for the A-D converter 713 on the image sensor circuit board 706 and a control signal 211 for the document illumination circuit board 707 and inputs the reference clock signal 208 and the control signal 211 into each of the A-D converter 713 and a document illumination driving circuit 718 via the cable 703, respectively. The document illumination driving circuit 718 inputs a document illumination driving signal 719 into the document illumination circuit board 707 via a cable 720.

The control circuit 205 generates a reference signal 214 for controlling a reading unit driving motor 202 to move the reading unit 702 and inputs the reference signal 214 into a motor driving circuit 212. The motor driving circuit 212 converts the reference signal 214 generated by the control circuit 205 into a motor driving signal to control the reading unit driving motor 202.

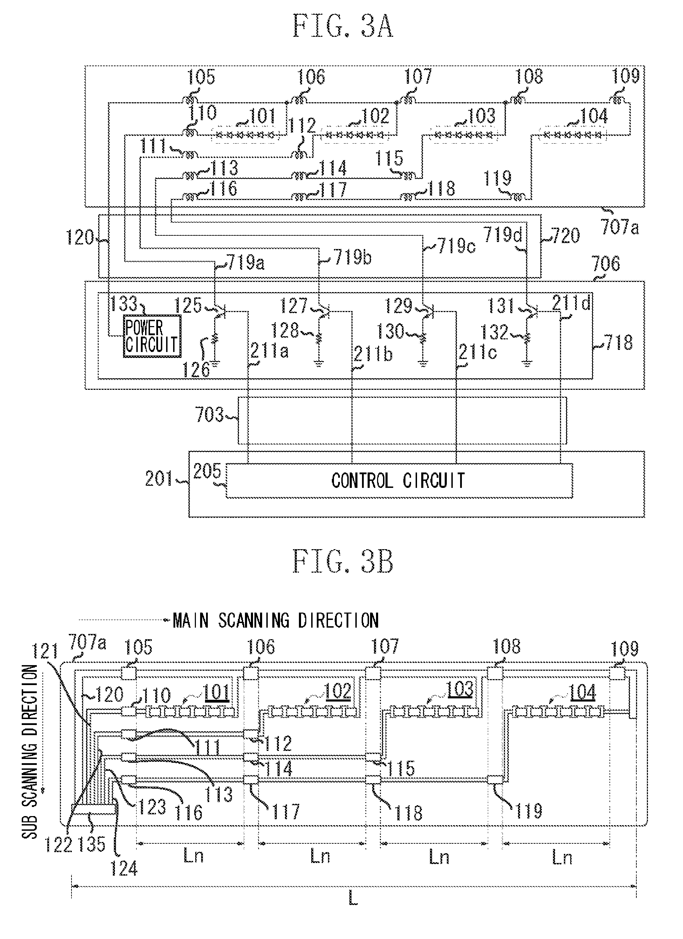

Fig. 3A illustrates a circuit diagram of the document illumination circuit board 707a, and Fig. 3B illustrates a wiring pattern of the document illumination circuit board 707a constructed by using a single-sided circuit board. The document illumination circuit board 707b has the similar configuration to the document illumination circuit board 707a.

As illustrated in Fig. 3B, LED modules 101 to 104 including a plurality of LEDs are arranged in a row on the document illumination circuit board 707a in the main scanning direction.

A power circuit 133 in the document illumination driving circuit 718 on the image sensor circuit board 706 supplies a predetermined direct current (DC) voltage 120 to the LED modules 101 to 104. The LED modules 101 to 104 turn ON/OFF at predetermined timing according to document illumination driving signals 719a to 719d (corresponding to patterns 121 to 124) from the document illumination driving circuit 718. A DC voltage 120 and the document illumination driving signals 719a to 719d are connected to a cable 720 via a connector 135.

The document illumination driving circuit 718 has individual driving circuits corresponding to each of the LED modules 101 to 104. The driving circuits turn ON/OFF according to control signals 211a to 211d output from the control circuit 205 on the control circuit board 201. The driving circuits include switching elements 125, 127, 129 and 131 and current-limiting resistors 126, 128, 130, 132 for determining current values flowing into the respective LED modules during turning-on.

The DC voltage 120 supplied to the respective LED modules and the document illumination driving signals 719a to 719d are connected via inductors 105 to 119 disposed at predetermined intervals. The respective inductors are made of a magnetic material.

As illustrated in Fig. 3B, the inductors 105 to 119 are arranged at a predetermined interval Ln in the main scanning direction of a wiring pattern formed on the document illumination circuit board 707a. The length Ln in the longitudinal direction of the wiring pattern divided by the inductors is a length satisfying the following equation (1):

$$\mathrm{L\,n} < \lambda \diagup (2 \times \sqrt{\varepsilon_1 \mu_1}) \tag{1}$$

wherein $\lambda$ is a wavelength in the air at a maximum frequency in a range of regulation of electromagnetic radiation, $\varepsilon_1$ is a relative permeability of the document illumination circuit board (medium), and $\mu_1$ is a relative permittivity of the document illumination circuit board (medium).

Generally, the radiation noise generated at an electronic apparatus is regulated by regulation for electromagnetic radiation by Voluntary Control Council for Information Technology Equipment (VCCI), Federal Communications Commission (FCC) and International Electrotechnical Commission (IEC). $\lambda$ can desirably be a wavelength at a maximum frequency regulated by the regulation for electromagnetic radiation.

The reason for the aforementioned will be described below. The image sensor driving circuit 714 supplies the image sensor driving signal 717 (pulse signal (rectangular wave)) of a predetermined frequency $f_0$ to the image sensor 711. The pulse signal (rectangular wave) includes a harmonic component that causes a radiation noise. When the image sensor 711 is a charge coupled device (CCD) (a capacitive load), the image driving signal 717 requires high current capacity, which becomes a large radiation-noise source.

Although the image sensor circuit board 706 is connected to the control circuit board 201 via the cable 703, the cable 703 is long, and the image sensor circuit board 706 is not grounded in a high-frequency area. Accordingly, a radiation noise tends to radiate from the image sensor circuit board 706 to the outside of the circuit board. The frequency of a generated radiation noise is a frequency $f_0$ and its harmonic component fn (n: an integer).

Although the document illumination circuit boards 707a and 707b are connected to the image sensor circuit board 706 via the cable 720, the cable 720 is long, and the document illumination circuit boards 707a and 707b are not grounded in a high-frequency area. Specifically, the wiring pattern on the document illumination circuit board 707 disposed in the vicinity of the image sensor circuit board 706, which is a radiation noise source, is equivalent to a conductor under a floating state in a high-frequency area. Accordingly, resonance may occur at the wiring pattern that has undergone the radiation noise radiated from the image sensor circuit board 706 depending upon relationship between a driving frequency of the image sensor 711 and a length L of the wiring pattern. When resonance occurs at the wiring pattern, the wiring pattern functions as a half wavelength antenna that radiates a radiation noise.

To prevent such a phenomenon, impedance elements (inductors 105 to 119) are mounted on the wiring pattern provided in the vicinity of the radiation noise source at the interval Ln. Specifically, the wiring pattern is divided by the distance Ln and a space between the divided wiring patterns is connected via an impedance element (inductor). Accordingly, generation of resonance on the wiring pattern can be prevented, thus preventing the wiring pattern from functioning as an antenna for radiation noise.

The wiring pattern length of the document illumination circuit board 707 in the main scanning direction has been described above as an example, and when the wiring pattern length in the sub scanning direction does not satisfy equation (1), the inductances may be mounted at such an interval as to satisfy equation (1).

The LED modules 101 to 104 are driven by a DC voltage, and therefore the inductors 105 to 119 do not affect turning ON/OFF of the LED modules 101 to 104.

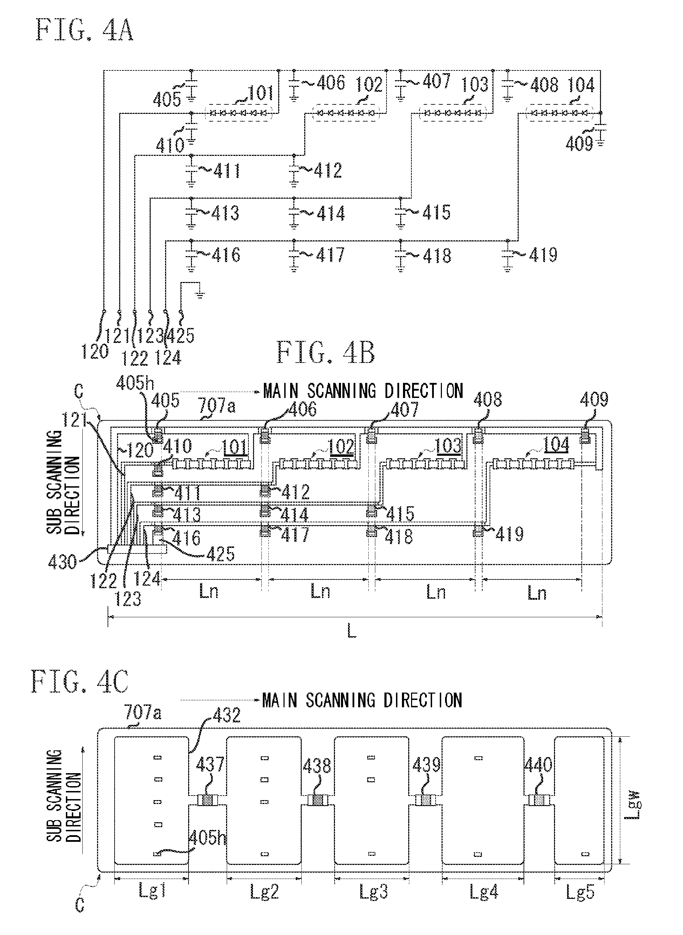

A second exemplary embodiment of the present invention will be described below. In the first exemplary embodiment, the inductors 105 to 119 are arranged as impedance elements, use of capacitors provides similar advantages. Figs. 4A, 4B, and 4C illustrate a document illumination circuit board 707a with capacitors 405 to 419 disposed thereon. The document illumination circuit board 707a according to the present exemplary embodiment is a double-sided circuit board. Fig. 4A illustrates a circuit diagram of the document illumination circuit board 707a, Fig. 4B is a view illustrating a wiring pattern on the front face of the document illumination circuit board 707a, and Fig. 4C is a view illustrating a wiring pattern on the rear face of the document illumination circuit board 707a. A corner C of the document illumination circuit board 707a illustrated in Fig. 4B corresponds to a corner C illustrated in Fig. 4C. The document illumination circuit board 707b is similar to the document illumination circuit board 707a.

The interval Ln with which the capacitors are arranged is set to be such a length as to satisfy the conditions illustrated in the first exemplary embodiment. The DC voltage 120 and the document illumination driving signals 719a to 719d are connected to the cable 720 described in the first exemplary embodiment via a connector 430.

One terminal of the capacitor 405 is connected with a wiring pattern of the DC voltage 120 and the other terminal is connected to a ground pattern 432 of the rear face via a through hole 405h. A wiring pattern 425 and a ground pattern 432 are grounded to the upper frame 701 and the lower frame 709. Ground terminals of the capacitors 406 to 419 are also connected in a similar way as of the capacitor 405. Thus, generation of resonance at wiring patterns of the DC voltage 120 and the document illumination driving signals 719a to 719d can be prevented.

When the ground pattern 432 is formed to have a uniform width and a length approximate to that of the document illumination circuit board 707a in the main scanning direction, resonance may occur at the ground pattern that has received radiation noise.

The ground pattern 432 is formed into a plurality of island shapes between which inductors 437 to 440 are provided. Such a configuration prevents generation of resonance in each area (island) of the ground pattern. A length $Lg_1$ of the island of the ground pattern 432 is set to be such a length as to satisfy the following equation (2). Lengths $Lg_2$ to $Lg_5$ of other islands of the ground pattern 432 and a width Lgw of the ground pattern 432 are set to be such a length as to satisfy the same condition as $Lg_1$.

$$Lg_1 < \lambda \diagup (2 \times \sqrt{\varepsilon_1 \mu_1}) \qquad (2)$$

wherein $\lambda$ is a wavelength in the air at a maximum frequency in a range of regulation for electromagnetic radiation, $\varepsilon_1$ is a relative permeability of the document illumination circuit board (medium), and $\mu_1$ is a relative permittivity of the document illumination circuit board (medium).

Accordingly, even if the wiring pattern on the document illumination circuit board 707 receives radiation noise, no resonance occurs on the wiring pattern.

A third exemplary embodiment of the present invention will be described below. The first and the second exemplary embodiments have described the document illumination circuit board. For the image sensor circuit board as well, use of a similar measure prevents generation of resonance in the wiring pattern on the image sensor circuit board.

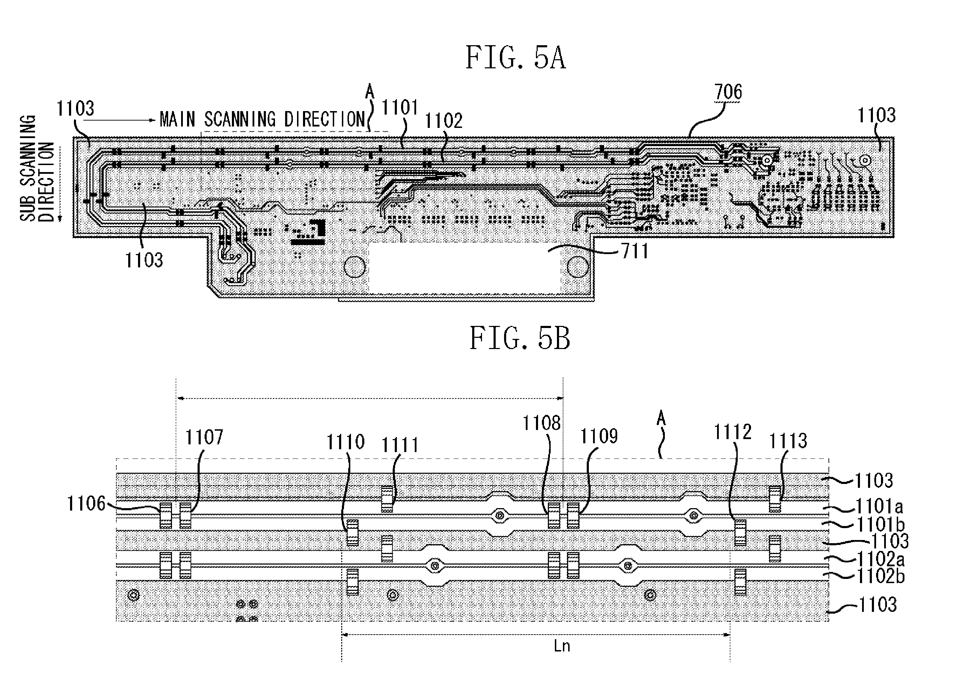

Fig. 5A illustrates the wiring pattern on the image sensor circuit board 706 according to the second exemplary embodiment of the present invention, and Fig. 5B is an enlarged view of an area A in Fig. 5A.

Wiring patterns 1101 and 1102 are formed along an outer periphery of the image sensor circuit board 706, and a ground pattern 1103 is formed therearound. The ground pattern 1103 is grounded. The wiring pattern 1101 includes a pair of parallel wiring patterns 1101a and 1101b to transmit a control signal. The wiring pattern 1102 includes a pair of parallel wiring patterns 1102a and 1102b to transmit a control signal.

In the present exemplary embodiment, capacitors 1106 to 1109 are provided between the wiring patterns 1101a to 1101b. Capacitors 1111 and 1113 are provided between the wiring pattern 1101a and the ground pattern 1103. Further, capacitors 1110, 1112 are provided between the wiring pattern 1101b and the ground pattern 1103. The reason why the capacitors 1106 and 1107 are provided in parallel in the vicinity of each other is to provide a predetermined capacity.

The distance Ln between the capacitor 1110 and 1112 is set to be such a distance as to satisfy the following equation (3) :

$$Ln < \lambda \diagup (2 \times \sqrt{\varepsilon_2 \mu_2}) \qquad (3)$$

wherein $\lambda$ is a wavelength in the air at a maximum frequency in a range of regulation for electromagnetic radiation, $\varepsilon_2$ is a relative permeability of the image sensor circuit board 706 (medium), and $\mu_2$ is a relative permittivity of the image sensor circuit board 706 (medium).

Hence, even if the wiring pattern on the image sensor circuit board 706 receives a radiation noise, no resonance occurs on the wiring pattern.

A fourth exemplary embodiment of the present invention will be described below. In the case of the reflectors 708a and 708b made of a conductive material as well as the wiring pattern described above, resonance may occur at a conductive member of the reflectors 708a and 708b in a similar way as for the wiring pattern.

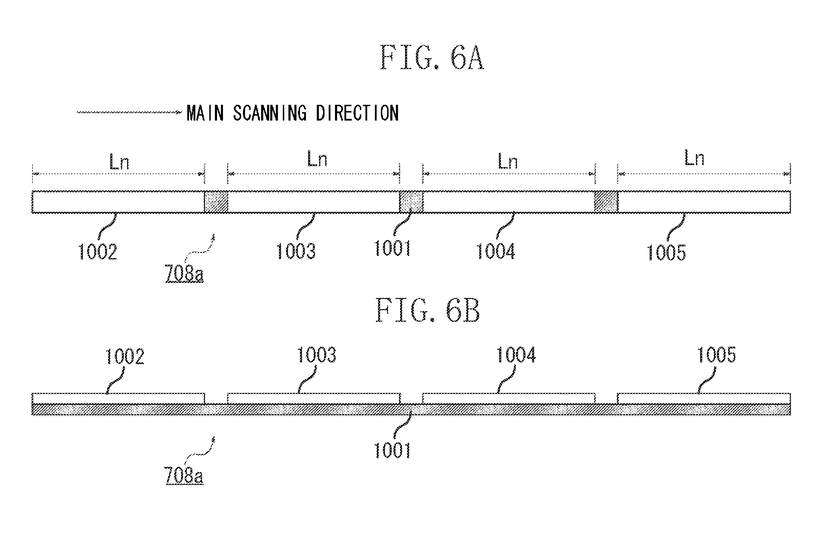

Fig. 6A is a top view of a reflector 708a and Fig. 6B is a sectional view of a reflector 708b in the present exemplary embodiment. The configuration of the reflector 708b is similar to the reflector 708a. On a base member 1001 of the reflector 708a, the reflecting surfaces 1002 to 1005 (a plurality of vapor-deposited metal films) are arranged. A portion between the reflecting surfaces 1002 and 1003 is insulated without any vapor-deposited metal film. The portions between other reflecting surfaces are formed similarly. The length Ln of one side of each of the reflecting surfaces 1002 to 1005 is set to be such a length as to satisfy the following equation (4):

$$\mathrm{Ln} < \lambda / (2 \times \sqrt{\varepsilon_3 \mu_3})$$
(4)

wherein $\lambda$ is a wavelength in the air at a maximum frequency in a range of regulation for electromagnetic radiation, $\varepsilon_3$ is a relative permeability of the reflector 708 (medium), and $\mu_3$ is a relative permittivity of the reflector 708 (medium).

Hence, even if the vapor-deposited metal film on the reflector 708 receives a radiation noise, no resonance occurs on the vapor-deposited metal film.

Although the present invention is described with the exemplary embodiments, the present invention is not limited to an image reading apparatus and can be applied to an electronic apparatus that includes a circuit board having a wiring pattern formed of a conductor and operates in accordance with a driving signal of a predetermined frequency. Even in this case, onto a wiring pattern having a length equal to or larger than a predetermined length at which resonance may be generated caused by a driving signal of a predetermined frequency, impedance elements are provided at an interval smaller than the predetermined length. Thus, the radiation noise can be prevented. The impedance element may be inductors inserted into a wiring pattern in series or a capacitor connected between a wiring pattern and a ground pattern.

While the present invention has been described with reference to exemplary embodiments, it is to be understood that the invention is not limited to the disclosed exemplary embodiments. The scope of the following claims is to be accorded the broadest interpretation so as to encompass all modifications, equivalent structures, and functions.

**Claims**

1. An electronic apparatus (701) that operates in accordance with a driving signal having a predetermined frequency, the electronic apparatus comprising:

   a circuit board (707) including a wiring pattern made of a conductor,

   wherein an impedance element (105 to 109) is provided at an interval smaller than a predetermined length onto a wiring pattern having a length equal to or larger than the predetermined length at which resonance is generated due to the driving signal having the predetermined frequency.

2. The electronic apparatus according to claim 1, wherein the impedance element is an inductor inserted in series between the wiring patterns.

3. The electronic apparatus according to claim 1, wherein the impedance element is a capacitor connected between the wiring pattern and a ground pattern.

4. The electronic apparatus according to claim 1, further comprising an image sensor that operates in accordance with the driving signal having the predetermined frequency to read a document, wherein the circuit board includes a light source configured to expose the document and a wiring pattern configured to turn on the light source.

5. The electronic apparatus according to claim 1, wherein the circuit board includes an image sensor that operates in accordance with a driving signal having the predetermined frequency to read a document.

**6.** The electronic apparatus according to claim 4, further comprising a reflector configured to reflect light from the light source toward a document,
wherein the reflector includes a plurality of metal films to reflect light and a length of one side of each of the films is less than the predetermined length.

FIG. 1A

MAIN SCANNING DIRECTION

SUB SCANNING DIRECTION

FIG. 1B

# FIG. 2

DOCUMENT ILLUMINATION UNIT ~702

707

~720

IMAGE SENSOR ~711 ~706

~719

718 714 ~717 ~715

DOCUMENT ILLUMINATION UNIT DRIVING CIRCUIT

IMAGE SENSOR DRIVING CIRCUIT

AMPLIFIER ~712

202

READING UNIT DRIVING MOTOR

A/D ~713

~211 208 209~ ~703

207~

201

CONTROL CIRCUIT

IMAGE PROCESSING CIRCUIT

INTERFACE CIRCUIT

MOTOR DRIVING CIRCUIT

205 204 213 212

MICROCOMPUTER

214

FIG. 3A

FIG. 3B

MAIN SCANNING DIRECTION

SUB SCANNING DIRECTION

POWER CIRCUIT

CONTROL CIRCUIT

FIG. 4A

FIG. 4B

MAIN SCANNING DIRECTION

FIG. 4C

MAIN SCANNING DIRECTION

FIG. 5A

FIG. 5B

# FIG. 6A

MAIN SCANNING DIRECTION

Ln          Ln          Ln          Ln

1002          1003    1001    1004          1005

708a

# FIG. 6B

1002          1003          1004          1005

1001

708a

EP 2 129 198 A1

Europäisches
Patentamt

European
Patent Office

Office européen
des brevets

**EUROPEAN SEARCH REPORT**

Application Number

EP 09 15 9826

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 02/103838 A (NOKIA CORP [FI]; PASSIOPOULOS GEORGE [GB]; KOKKONEN ILPO [FI]; SALMELA) 27 December 2002 (2002-12-27) * page 2, line 1 - line 13 * * claim 1; figure 3 * ----- | 1-3 | INV. H05K3/04 H05K3/10 H05K3/42 |
| X | US 2008/048796 A1 (SHAUL YIGAL [US] ET AL) 28 February 2008 (2008-02-28) * paragraph [0006] - paragraph [0007] * * paragraph [0030] - paragraph [0043] * ----- | 1-3 | |
| A | US 6 016 084 A (SUGIMOTO SATOSHI [JP]) 18 January 2000 (2000-01-18) * column 5, line 19 - column 6, line 5 * ----- | 1-6 | |

TECHNICAL FIELDS
SEARCHED      (IPC)

H05K

The present search report has been drawn up for all claims

| Place of search | Date of completion of the search | Examiner |
|---|---|---|
| The Hague | 9 July 2009 | Pacholec, Darek |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 09 15 9826

This annex lists the patent family members relating to the patent documents cited in  the above-mentioned European search report.
The members are as contained in the European Patent Office EDP file on
The European Patent Office is in no way liable for these particulars which are merely given for the purpose of information.

09-07-2009

| Patent document cited in search report | | Publication date | Patent family member(s) | | Publication date |
|---|---|---|---|---|---|
| WO 02103838 | A | 27-12-2002 | US | 2004159460 A1 | 19-08-2004 |
| US 2008048796 | A1 | 28-02-2008 | NONE | | |
| US 6016084 | A | 18-01-2000 | NONE | | |

EPO FORM P0459

**EP 2 129 198 A1**

## REFERENCES CITED IN THE DESCRIPTION

**Patent documents cited in the description**

- JP 8195860 A

- JP 2308667 A